# EUROPÄISCHE PATENTSCHRIFT

(11) **EP 0 901 010 B1**
(45) Veröffentlichungstag und Bekanntmachung des Hinweises auf die Patenterteilung: **16.04.2003**
(21) Anmeldenummer: 98114222.7
(22) Anmeldetag: 29.07.1998
(51) Int. Cl.: G01N 21/88

(54) **Kalibrierwafer**
Reference wafer
Tranche de silicium de référence

(30) Priorität: 27.08.1997 DE 19737363
(43) Veröffentlichungstag der Anmeldung: 10.03.1999
(73) Patentinhaber: Infineon Technologies AG, 81669 München (DE)
(72) Erfinder: Kurth, Kathrin, 01159 Dresden (DE); Horn, Michael, 01122 Dresden (DE); Geyer, Stefan, 01277 Dresden (DE); Goethel, Ralf, 01474 Schullwitz (DE)
(74) Vertreter: Kindermann, Peter, Dipl.-Ing.

(56) Entgegenhaltungen:
- US-A- 4 386 850
- US-A- 4 512 659
- US-A- 4 636 073
- US-A- 5 078 492
- US-A- 5 144 524
- US-A- 5 198 869
- US-A- 5 383 018

## Beschreibung

Die Erfindung betrifft einen Kalibrierwafer nach dem Oberbegriff des Patentanspruches 1 sowie Verfahren zu seiner Herstellung nach den Oberbegriffen der Patentansprüche 3 und 4.

Die Herstellung von Halbleiterbauelementen (zum Beispiel integrierte Schaltkreise aus im wesentlichen Silizium) erfolgt bekanntlich unter sogenannten Reinraumbedingungen, das heißt in einer Umgebung, die möglichst wenig sogenannte Partikel (= Schmutzteilchen) aufweist. Das Vorhandensein der jeweils geforderten Reinraum- und Prozeßbedingungen wird regelmäßig und gegebenenfalls bei Bedarf (zum Beispiel Verschlechterung der Qualität und/oder der Ausbeute der Bauelemente) überprüft, unter anderem mittels sogenannter Oberflächenpartikelmeßgeräte. Zur Kalibrierung dieser Meßgeräte werden spezielle Wafer verwendet, allgemein bekannt als Kalibrierwafer.

Kalibrierwafer nach dem Stande der Technik sind Halbleiterscheiben, deren Oberfläche mit Polymerkügelchen versehen ist, in vorgegebener Menge und Größenordnung, wobei das Aufbringen der Polymerkügelchen mittels einer definiert verdünnten Polymerkügelchendispersion erfolgt. Solcherart hergestellte Kalibrierwafer weisen also Polymerkügelchen auf mit einer vorgegebenen Menge, einer vorgegebenen Ortsverteilung (auf dem Kalibrierwafer) und mit einer vorgegebenen Größenverteilung. Das Herstellverfahren für diese Kalibrierwafer ist sehr aufwendig. Zwischen den einzelnen Überprüfungen der Reinraumbedingungen werden die Kalibrierwafer zwar unter Reinraumbedingungen gelagert. Da sich jedoch auch bei optimalen, technisch realisierbaren Reinraumbedingungen immer noch Spuren von zum Beispiel Ammoniak, Salzsäure, Flußsäure und ähnlichem in der Luft befinden, lagern sich diese mit der Zeit (auch) auf den Kalibrierwafern ab, zum Beispiel in Form von Ammoniumsalzen.

Diese Ablagerungen verfälschen mit der Zeit jedoch die sogenannte Kalibrierung, was im Extremfall dazu führt, daß eine Kalibrierung nicht mehr möglich ist.

Zwar lassen sich die Ablagerungen in der Regel problemlos mittels Wasser abspülen, jedoch werden dabei auch die Polymerkügelchen ebenfalls von den Wafern mit entfernt. Sie müssen deshalb mittels des bislang bekannten, sehr aufwendigen Verfahrens erneut aufgebracht werden.

Aufgabe der vorliegenden Erfindung ist es, Kalibrierwafer zu schaffen, die samt ihrer aufgebrachten Polymerkügelchen öfter verwendbar sind als bislang, sowie ein Verfahren anzugeben, mit dem solche Kalibrierwafer herstellbar sind.

Diese Aufgabe wird gelöst bei einem gattungsgemäßen Kalibrierwafer mittels der kennzeichnenden Merkmale des Patentanspruches 1 sowie bei den gattungsgemäßen Herstellverfahren mittels der kennzeichnenden Merkmale der Patentansprüche 3 und 4.

Die Erfindung wird nachstehend anhand einer Figur erläutert, die einen Kalibrierwafer W samt Polymerkügelchen P zeigt. Die auf dem Kalibrierwafer W dargestellten Polymerkügelchen P sind dabei nur symbolisch gezeigt, da sich in der Regel wesentlich mehr Polymerkügelchen P als die dargestellte Anzahl auf einem solchen Wafer W befinden und da diese Polymerkügelchen P trotz unterschiedlicher Größen jeweils wesentlich kleiner sind als dargestellt.

Bei dem erfindungsgemäßen Kalibrierwafer W sind die Polymerkügelchen P mittels einer speziellen Wärmebehandlung auf dem Wafer W fixiert, die in einem Temperaturbereich erfolgt, bei dem die Polymerkügelchen P gerade zu erweichen beginnen. Als günstiger Temperaturbereich hat sich dabei ein Temperaturbereich von 80°C bis 95°C erwiesen. Der jeweilige Temperaturbereich ist natürlich von der jeweiligen Art des gewählten Polymers abhängig.

Der Kalibrierwafer W kann entweder dadurch hergestellt werden, daß die Temperaturbehandlung im gewählten Temperaturbereich, zum Beispiel 80°C bis 95°C, entweder während des Aufbringens der Polymerkügelchen P auf den Kalibrierwafer W erfolgt oder erst nach deren (P) Aufbringen.

Der Vorteil eines solchen erfindungsgemäßen Kalibrierwafers W und der gezeigten Herstellverfahren liegt darin, daß bei einem wie eingangs dargestellten Abwaschen von Ablagerungen (zum Beispiel die erwähnten Ammoniumsalze) von einem erfindungsgemäßen Kalibrierwafer W die Polymerkügelchen P nicht ebenfalls entfernt werden (wie bezüglich des Standes der Technik geschildert), sondern daß sie auf dem Kalibrierwafer W aufgrund der erfolgten Temperaturbehandlung haften bleiben. Damit können erfindungsgemäße Kalibrierwafer W wesentlich öfter und wesentlich länger verwendet werden als solche nach dem Stand der Technik, was zu einer wesentlichen Kostenersparnis führt: Das aufwendige Aufbringen von Polymerkügelchen P ist wesentlich seltener notwendig als bislang. Versuche haben gezeigt, daß bei Herstellen und Benutzen von erfindungsgemäßen Kalibrierwafern W die Anzahl pro Jahr auf 10% der bislang benötigten Menge reduziert werden kann.

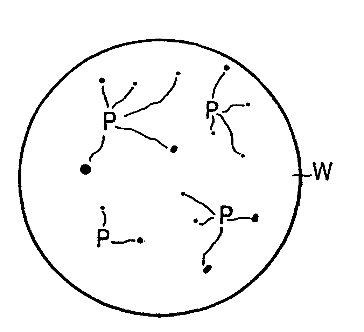

## Patentansprüche

1. Kalibrierwafer mit darauf haftenden Polymerkügelchen (P),
**dadurch gekennzeichnet,**
**daß** die Polymerkügelchen (P) mittels einer Wärmebehandlung fixiert sind, wobei die Wärmebehandlung in einem Temperaturbereich erfolgt, bei dem die Polymerkügelchen (P) zu erweichen beginnen.

2. Kalibrierwafer nach Anspruch 1,
**dadurch gekennzeichnet,**
**daß** der Temperaturbereich 80°C bis 95°C umfaßt.

3. Verfahren zum Herstellen eines Kalibrierwafers (W), bei dem Polymerkügelchen (P) auf den Kalibrierwafer (W) aufgebracht werden,
**dadurch gekennzeichnet,**
**daß** das Aufbringen mittels einer Temperaturbehandlung in einem Temperaturbereich erfolgt, bei dem die Polymerkügelchen (P) zu erweichen beginnen.

4. Verfahren zum Herstellen eines Kalibrierwafers (W), bei dem Polymerkügelchen (P) auf den Kalibrierwafer (W) aufgebracht werden,
**dadurch gekennzeichnet,**
**daß** der Kalibrierwafer (W) samt den darauf aufgebrachten Polymerkügelchen (P) nach deren Aufbringen einer Temperaturbehandlung unterzogen wird in einem Temperaturbereich, bei dem die Polymerkügelchen (P) zu erweichen beginnen.

5. Verfahren nach Anspruch 3 oder 4,
**dadurch gekennzeichnet,**
**daß** die Temperaturbehandlung bei 80°C bis 95°C durchgeführt wird.

## Claims

1. Calibrating wafer having polymer microspheres (P) adhering to it, **characterized in that** the polymer microspheres (P) are fixed by means of a heat treatment, the heat treatment being carried out in a temperature range in which the polymer microspheres (P) start to soften.

2. Calibrating wafer according to Claim 1, **characterized in that** the temperature range covers 80°C to 95°C.

3. Method for the production of a calibrating wafer (W), in which polymer microspheres (P) are applied to the calibrating wafer (W), **characterized in that** the application is carried out by means of a heat treatment in a temperature range in which the polymer microspheres (P) start to soften.

4. Method for the production of a calibrating wafer (W), in which polymer microspheres (P) are applied to the calibrating wafer (W), **characterized in that** the calibrating wafer (W), together with the polymer microspheres (P) applied to it, are subjected, after the latter have been applied, to a heat treatment in a temperature range in which the polymer microspheres (P) start to soften.

5. Method according to Claim 3 or 4, **characterized in that** the heat treatment is carried out at from 80°C to 95°C.

## Revendications

1. Tranche d'étalonnage sur laquelle adhèrent de petites sphères (P) en polymère, **caractérisée**
**en ce que** les petites sphères (P) en polymère sont immobilisées au moyen d'un traitement thermique, le traitement thermique s'effectuant dans une plage de températures dans laquelle les petites sphères (P) en polymère commencent à se ramollir.

2. Tranche d'étalonnage suivant la revendication 1,
**caractérisée**
**en ce que** la plage de températures va de 80°C à 95°C.

3. Procédé de production d'une tranche (W) d'étalonnage, dans lequel on dépose de petites sphères (P) en polymère sur la tranche (W) d'étalonnage,
**caractérisé**
**en ce qu'**on effectue le dépôt au moyen d'un traitement en température dans une plage de températures dans laquelle les petites sphères (P) en polymère commencent à se ramollir.

4. Procédé de production d'une tranche (W) d'étalonnage, dans lequel on dépose de petites sphères (P) en polymère sur la tranche (W) d'étalonnage,
**caractérisé**
**en ce que** l'on soumet la tranche (W) d'étalonnage ainsi que les petites sphères (P) en polymère qui y sont déposées après leur dépôt à un traitement en température dans une plage de températures dans laquelle les petites sphères (P) en polymère commencent à se ramollir.

5. Procédé suivant la revendication 3 ou 4, **caractérisé en ce que** l'on effectue le traitement en température entre 80°C et 95°C.
